# EUROPEAN PATENT APPLICATION

(11) **EP 4 807 743 A1**
(43) Date of publication of application: **16.09.2026**
(21) Application number: 25195824.5
(22) Date of filing: 14.08.2025
(51) Int. Cl.: G11C 11/56, G11C 16/34, G11C 29/02, G11C 16/26

(54) **METHOD AND APPARATUS FOR PERFORMING READ OPERATION ON A MEMORY BLOCK OF A STORAGE DEVICE**

(30) Priority: 13.03.2025 IN 202541022703; 17.06.2025 IN 202541022703; 22.07.2025 US 202519276736
(71) Applicant: Samsung Electronics Co., Ltd., Suwon-si, Gyeonggi-do 16677 (KR)
(72) Inventor: ANANTHAPALLI, Sandeep Kumar, 560048 Bengaluru, Karnataka (IN); BIPINBHAI, Solanki Bhavadip, 560048 Bengaluru, Karnataka (IN); GURRALA, Naveen, 560048 Bengaluru, Karnataka (IN); KANNIAH, Pandi, 560048 Bengaluru, Karnataka (IN)
(74) Representative: Kuhnen & Wacker Patent- und Rechtsanwaltsbüro PartG mbB

(57) **Abstract**

A method and an apparatus for performing a read operation on a memory block of a storage device. The method includes determining an optimal read level voltage for a current memory block, based on a failure of a read operation performed on the current memory block; performing, based on the optimal read level voltage determined for the current memory block, one of: determining a recalibrated read level voltage for an existing read level cluster among one or more existing read level clusters created previously for one or more memory blocks of the storage device; and creating a new read level cluster with respect to the optimal read level voltage; and performing, based on a subsequent read operation request for the current memory block, the read operation on the current memory block based on the recalibrated read level voltage or the new read level voltage.

## Description

### CROSS-REFERENCE TO RELATED APPLICATION(S)

This application is based on and claims priority from Indian Provisional Patent Application No. 202541022703, filed on March 13, 2025, and Indian Non-Provisional Patent Application No. 202541022703, filed on June 17, 2025, in the Indian patent Office, the disclosure of which is incorporated herein by reference in its entirety.

### BACKGROUND

### 1. Field

The present disclosure relates to storage devices. Particularly, the present disclosure relates to a method and an apparatus for performing a read operation on a memory block of a storage device.

### 2. Description of the Related Art

Storage devices use solid-state technology to store data in arrays of memory cells built with floating gate transistors. Multiple arrays of these memory cells form a memory block, and the storage device contains a plurality of memory blocks. During a read operation, electrical charge levels of the memory blocks are compared to one or more voltage reference values (also referred to as read level voltages or voltage thresholds) to determine a state of the individual memory blocks. However, various factors may contribute to data read errors during the read operation. These factors may include charge loss or leakage of the memory blocks over time and device wear caused to the memory blocks by usage. A voltage distribution of the memory blocks also changes due to reliability issues such as data retention, read disturbance, and temperature variations. These changes in voltage distribution may require an adjustment in the read level voltages to accurately decode data from the memory blocks.

For adjusting the read level voltages, when the read operation fails, recovery algorithms may be triggered in the storage devices to find an optimal read level voltage of the memory block. However, the recovery algorithm, such as the Min Valley search (min Error search), may involve multiple iterations of reads on the same word line (WL) to find the optimal read level voltage. These algorithms are time-consuming and, when repeatedly triggered, lead to higher read latency. This increased latency may result in sluggish drive performance and, in extreme cases, a Blue Screen of Death (BSOD) when thousands of recoveries occur in the storage device. To optimize read latency, a memory device may cache the optimal read level voltage, also known as a history read level voltage, found by recovery algorithms.

The existing approach for caching these optimal read level voltages is inefficient. Furthermore, different memory blocks may undergo different reliability stress conditions, necessitating different history read level voltages. In the existing approach, the optimal read level voltages of each memory block are stored in a mapping table in the storage device. However, this approach has high memory consumption and is not viable for devices like dynamic random access (DRAM)-less products.

Therefore, there exists a need for a technique that reduces memory consumption and minimizes a need for repeated recovery scheme triggers, during performing read operations on a memory block.

### SUMMARY

According to an aspect of an example embodiment of the present disclosure, provided is a method of performing a read operation on a memory block of a storage device, by at least one processor. The method includes determining an optimal read level voltage for a current memory block, based on a failure of a read operation performed on the current memory block due to an incompatible read level voltage applied for the read operation; performing, based on the optimal read level voltage determined for the current memory block, one of: determining a recalibrated read level voltage for an existing read level cluster among one or more existing read level clusters created previously for one or more memory blocks of the storage device; and creating a new read level cluster with respect to a new read level voltage equivalent to the optimal read level voltage for the current memory block; and performing, based on a subsequent read operation request for the current memory block, the read operation on the current memory block based on the recalibrated read level voltage or the new read level voltage.

According to an aspect of an example embodiment of the present disclosure, provided is an apparatus for performing read operation on a memory block of a storage device. The apparatus includes at least one processor; and a memory, communicatively coupled to the at least one processor, wherein the memory stores instructions, which, on execution, causes the at least one processor to: determine an optimal read level voltage for a current memory block, based on a failure of a read operation performed on the current memory block due to incompatible read level voltage applied for the read operation; perform, based on the optimal read level voltage determined for the current memory block, one of: determine a recalibrated read level voltage for an existing read level cluster among one or more existing read level clusters created previously for one or more memory blocks of the storage device; and create a new read level cluster with respect to a new read level voltage equivalent to the optimal read level voltage for the current memory block; and perform, based on a subsequent read operation request for the current memory block, the read operation on the current memory block based on the recalibrated read level voltage or the new read level voltage.

The foregoing summary is illustrative only and is not intended to be in any way limiting. In addition to the illustrative aspects, embodiments, and features described above, further aspects, embodiments, and features will become apparent by reference to the drawings and the following detailed description.

### BRIEF DESCRIPTION OF DRAWINGS

Example embodiments will be more clearly understood from the following detailed description taken in conjunction with the accompanying drawings, in which:
FIG. 1 illustrates an example of a NAND chip plane, in accordance with one or more embodiments of the present disclosure;
FIG. 2A shows an example of an architecture for performing a read operation on a memory block of a storage device, in accordance with one or more embodiments of the present disclosure;
FIG. 2B shows an exemplary apparatus for performing a read operation on a memory block of a storage device, in accordance with one or more embodiments of the present disclosure;
FIG. 3A shows a detailed block diagram of an apparatus for performing a read operation on a memory block of a storage device, in accordance with one or more embodiments of the present disclosure;
FIG. 3B shows an exemplary illustration of one or more clusters, in accordance with one or more embodiments of the present disclosure;
FIG. 4 shows an exemplary flowchart illustrating a method of performing read operation on a memory block of a storage device, in accordance with one or more embodiments of the present disclosure; and
FIG. 5 illustrates a general computer system architecture, in accordance with one or more embodiments of the present disclosure.

### DETAILED DESCRIPTION

In the present document, the word "exemplary" is used herein to mean "serving as an example, instance, or illustration." Any embodiment or implementation of the present subject matter described herein as "exemplary" is not necessarily to be construed as preferred or advantageous over other embodiments.

While the disclosure is susceptible to various modifications and alternative forms, specific embodiment thereof has been shown by way of example in the drawings and will be described in detail below. It should be understood, however that it is not intended to limit the disclosure to the specific forms disclosed, but on the contrary, the disclosure is to cover all modifications, equivalents, and alternative falling within the scope of the disclosure.

The terms "comprises", "comprising", "includes", or any other variations thereof, are intended to cover a non-exclusive inclusion, such that a setup, device, or method that comprises a list of components or steps does not include only those components or steps but may include other components or steps not expressly listed or inherent to such setup or device or method. In other words, one or more elements in a system or apparatus proceeded by "comprises... a" does not, without more constraints, preclude the existence of other elements or additional elements in the apparatus or method.

It should be appreciated by those skilled in the art that any block diagrams herein represent conceptual views of illustrative systems embodying the principles of the present subject matter. Similarly, it will be appreciated that any flow charts, flow diagrams, state transition diagrams, pseudo code, and the like represent various processes which may be substantially represented in computer readable medium and executed by a computer or processor.

As disclosed herein, the term "read level cluster(s)" refer to group(s) of memory blocks that undergo similar conditioning processes. For each cluster, a single representative read level voltage may be stored in the cluster list.

As disclosed herein, the term "existing read level cluster(s)" refer to a read level cluster already present in the cluster list along with a representative read level voltage.

As disclosed herein, the term "optimal read level voltage" may refer to a read level voltage of a memory block, as obtained by a read recovery algorithm, i.e., a specific voltage level used to accurately read data from a memory block. This voltage is determined through the read recovery process, which adjusts and optimizes the voltage to ensure reliable data retrieval from memory cells that may have experienced wear or other conditioning effects.

As disclosed herein, the term "default read level voltage" may refer to a voltage with which the apparatus attempts to read from a memory block. This default read level voltage may be recommended by a NAND characteristic guide to ensure successful data reads.

As disclosed herein, the term "cluster list" or "history table" may refer to a table that includes one or more read level clusters, and their representative read level voltages.

As discussed in the background section, there is a need to provide a mechanism for reducing memory consumption and minimizing a need for repeated recovery scheme triggers, while performing read operations on a memory block. The present disclosure provides clustering blocks having similar reliability conditions and maintain a cluster list comprising one or more read level clusters and one or more representative read level voltages corresponding to the one or more read level clusters. The present disclosure provides a more efficient way to store read level voltages. Especially in dynamic random access (DRAM)-less devices, an absence of a dedicated DRAM for caching a complete and large list of read level voltages may lead to significant performance bottlenecks and increased wear on the DRAM-less devices such as a flash memory. Therefore, instead of maintaining the complete and large list of read level voltages for each memory block, the present disclosure may maintain a list of one or more read level clusters and one or more representative read level voltages thereof, resulting in a significantly lower memory footprint. The present disclosure may not only improve efficiency of a memory device but also enhance its overall performance and longevity. Additionally, reducing memory overhead translates to lower storage costs and improved energy efficiency.

In the following detailed description of some example embodiments of the disclosure, reference is made to the accompanying drawings that describes specific embodiments in which the disclosure may be practiced. These embodiments are described in sufficient detail to enable those skilled in the art to practice the disclosure, and it is to be understood that other embodiments may be utilized and that changes may be made without departing from the scope of the present disclosure. The following description is, therefore, not to be taken in a limiting sense.

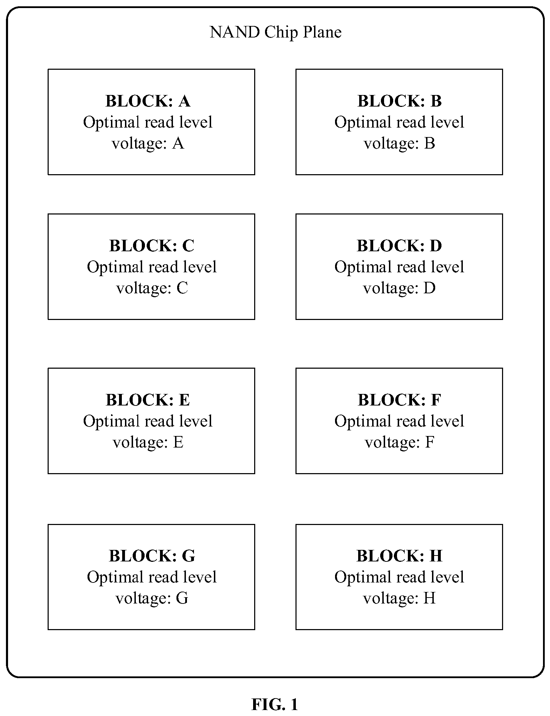

FIG. 1 illustrates an exemplary NAND chip plane, in accordance with one or more embodiments of the present disclosure. As depicted in FIG. 1, the NAND chip plane comprises memory blocks A to H, each with corresponding optimal read level voltages A to H. In the existing approach of caching most recent optimal read level voltages identified by a recovery scheme, a storage device caches four most recent read level voltages, such as A, B, C, and D, to ensure successful read operations for these blocks. However, when a host attempts to read blocks E, F, G, and H, a read operation fails and leads to an uncorrectable error correction code (UECC) error. This read operation failure triggers recovery algorithms and updates the cache with the read level voltages for E, F, G, and H. Consequently, when the storage device attempts to read blocks A, B, C, and D again, it results in triggering recovery algorithms, thereby increasing a number of recovery operations. To solve this problem, according to one or more embodiments, a method and an apparatus for performing a read operation on a memory block of a storage device that minimizes a need for repeated recovery scheme triggers, while performing a read operation on the memory block, are provided.

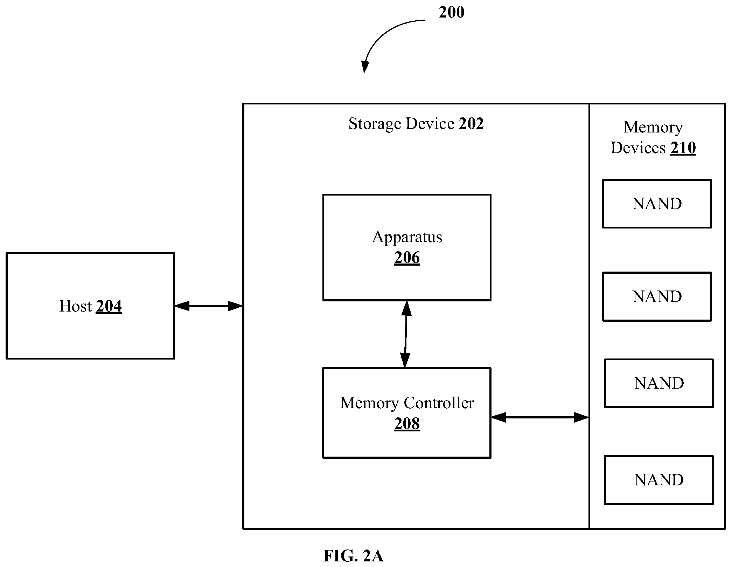

FIG. 2A shows an exemplary architecture 200 for performing read operation on a memory block of a storage device, in accordance with one or more embodiments of the present disclosure.

In an embodiment, the exemplary architecture 200 may include a storage device 202 and a host 204. In an embodiment, the storage device 202 may include, without limitation, an apparatus 206 for performing a read operation on a memory block of the storage device 202, a memory controller 208, and a plurality of memory devices 210.

In an embodiment, the storage device 202 may be a non-volatile storage device such as Solid-State Drive (SSD). In an embodiment, the storage device 202 may be, without limitation, a hybrid hard drive, DRAM-less SSD, any storage device utilizing solid-state memory, Non-Volatile Memory express (NVMe) based devices and the like.

In an embodiment, the storage device 202 may receive a read operation request or a write operation request from the host 204. For example, the host 204 may include, but not limited to, Personal Computers (PCs), such as desktops or laptops and other portable computers, tablets, mobile devices, cellular telephones, smartphones, Personal Digital Assistants (PDAs), gaming devices, digital still cameras, digital movie cameras, and portable media players. For portable memory card applications, a host may include a built-in receptacle for one or more types of memory cards or flash drives, or a host may require adapters into which a memory card is plugged.

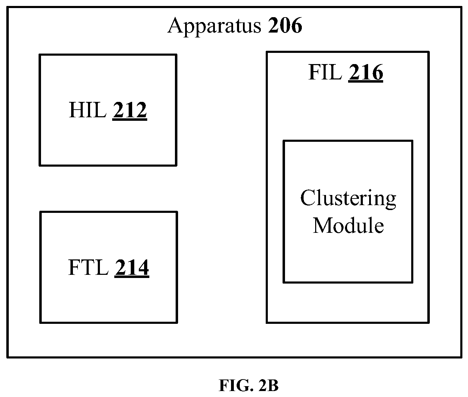

In an embodiment, upon receiving the read operation request from the host 204, the apparatus 206 (as shown in FIG. 2B) may perform read operation on a memory block of the storage device 202.

In some embodiments, upon receiving the read operation request from the host 204, the apparatus 206 may perform a read operation on the memory block of the storage device 202, through the memory controller 208 (as shown in FIG. 2A).

In an alternate embodiment, the memory controller 208 may control the memory device 202 to perform read operations on the memory block of the storage device 202. In an embodiment, the memory controller 208 (which may be a flash memory controller) may include processing circuitry, a microprocessor or processor, and a computer-readable medium that stores computer-readable program code (e.g., software or firmware) executable by the (micro) processor, logic gates, switches, an application specific integrated circuit (ASIC), a field-programmable gate array (FPGA), a programmable logic controller, and an embedded microcontroller, for example but not limited thereto. The memory controller 208 may be configured with hardware and/or firmware to perform various functions described in the present disclosure. The memory controller 208 may be configured to manage data flow between the storage device 202 and the host 204 and optimize read/write operations. The memory controller 208 may implement techniques like read/write caching, data prefetching, and wear leveling algorithms to improve performance and extend a lifespan of the NAND flash.

In some embodiments, in addition to performing a read operation and/or a write operation, the memory controller 208 may also control the storage device 202 to perform, for example, an operation related to a sudden power-off, a read reclaim operation, according to an internal request instead of a request from the host 204. Such a control operation may be referred to as a background operation.

In an embodiment, the storage device 202 may include a plurality of memory devices 210. For example, the plurality of memory devices 210 may be NAND flash memory chips (as shown in FIG. 2A as NAND). The plurality of memory devices 210 may include a plurality of memory cell arrays (not shown in the figure). These memory cell arrays may include memory cells located at the intersections of word lines (WL) and bit lines (BL). The memory cells may be flash memory cells, and the memory cell array may be a NAND flash memory cell array or a NOR flash memory cell array. Additionally, the memory cells may be resistive memory cells such as Resistive Random-Access Memory (RRAM) cells, Phase Change RAM (PRAM) cells, or Magnetic RAM (MRAM) cells.

In an embodiment, the memory cell array may be divided into a plurality of memory blocks (as shown in FIG. 1), with each memory block containing multiple memory cells. In some embodiments, the memory blocks may be divided according to word lines or pages. In another embodiment, the memory blocks may be organized based on word lines or pages. However, the disclosure is not limited to these methods, and the memory blocks may be divided according to arbitrary program units.

FIG. 2B shows an exemplary apparatus 206 for performing a read operation on a memory block of a storage device, in accordance with one or more embodiments of the present disclosure.

In an embodiment, the apparatus 206 for performing a read operation, may include, without limitation, Host Interface Layer (HIL) 212, Flash Translation Layer (FTL) 214, and Flash Interface Layer (FIL) 216. In an embodiment, the functionality of the apparatus 206 may be implemented in the firmware of the storage device 202.

In an embodiment, the HIL 212 may act as a bridge between the host 204 and the storage device 202. The HIL 212 may handle communication protocols and data transfer between the host 204 and the storage device 202. In an embodiment, the HIL 212 may receive read and/or write commands and/or requests from the host 204, translate the commands into appropriate operations, and send the results back to the host 204.

In an embodiment, the FTL 214 may manage the mapping between logical addresses used by the host 204 and physical addresses within the plurality of memory devices 210 (e.g. NAND flash).

In an embodiment, the FIL 216 may perform read operation or write operation on one or more memory blocks, based on requests received from the host 204. In an embodiment, the FIL 216 may also include a clustering module. In an embodiment, the clustering module may group the one or more memory blocks that undergo similar conditioning processes, as read level clusters. In an embodiment, the clustering module may also maintain a cluster list (also referred to as a history table in the present disclosure), where a single representative read level voltage is stored for each read level cluster.

At an initial startup of the storage device 202, the read level clusters may not yet be established, resulting in an empty cluster list. Upon receiving a read operation request from the host 204, the apparatus 206 may perform a read operation on a memory block (the memory block on which the read operation is to be performed is referred to as current memory block) of the storage device 202 using a default read level voltage. If the default read level voltage is an incompatible read level voltage for performing the read operation of the current memory block, the read operation fails. As an example, the read operation on the current memory block fails when the default read level voltage (e.g., 3.3V) is an incompatible read level voltage for performing the read operation of the current memory block (which may require 2.5V or 3.0V). When a read operation is performed with an incompatible read level voltage, an error may occur in the retrieved data. For example, if original data stored is '01' and the read voltage is incompatible, the read data may be '11' due to a single-bit error. In such cases, the apparatus 206 may have to retry the read operation with a different voltage to recover the correct data.

In some embodiments, when the read operation on the current memory block fails because the default read level voltage is an incompatible read level voltage for performing the read operation of the current memory block, the apparatus 206 may check whether there exists a cluster list to determine if any read level voltages corresponding to one or more existing read level clusters (i.e., read level clusters already established in the cluster list) are compatible for performing the read operation.

In some embodiments, upon determining that the cluster list is empty (as there are no clusters previously created), the apparatus 206 may analyze received read operation requests from the host 204 and the read level voltages of the one or more memory blocks. Based on this analysis, the apparatus 206 may trigger a read recovery technique (or algorithm) and determine an optimal read level voltage for the current memory block. Further, the apparatus 206 may create a new read level cluster with a new read level voltage equivalent to the optimal read level voltage for the current memory block.

In an embodiment, the apparatus 206 may store the new read level cluster and representative new read level voltage, in the cluster list. Subsequently, the apparatus 206 may perform the read operation on the current memory block based on the new read level voltage in response to a future read operation request received for the current memory block.

In an embodiment, when the read level clusters are already established, upon receiving the read operation request from the host 204, the apparatus 206 may perform the read operation on the memory block of the storage device 202 using the default read level voltage. If the read operation on the current memory block fails because the default read level voltage is an incompatible read level voltage for performing the read operation of the current memory block, the apparatus 206 may check the cluster list to determine if one or more existing read level voltages corresponding to the one or more existing read level clusters (one or more read level clusters already established in the cluster list) are compatible for performing the read operation.

Upon determining that at least one existing read level voltage of the one or more existing read level voltages corresponding to the one or more existing read level clusters (one or more read level clusters already established in the cluster list) is compatible for performing the read operation, the apparatus 206 may perform the read operation on the current memory block based on the at least one existing read level voltage, thereby preventing triggering of the read recovery technique.

In an embodiment, upon determining that any of the existing read level voltages corresponding to the one or more existing read level clusters (read level clusters already established in the cluster list) is compatible for performing the read operation, the apparatus 206 may trigger the read recovery algorithm and determine the optimal read level voltage for the current memory block. In an embodiment, when the optimal read level voltage determined for the current memory block is determined to be similar to the existing read level voltage of the existing read level cluster among the one or more existing read level clusters, based on a predefined similarity threshold, the apparatus 206 may determine a recalibrated read level voltage. The apparatus 206 may determine the recalibrated read level voltage for an existing read level cluster among one or more existing read level clusters created previously for one or more memory blocks of the storage device. In an embodiment, the apparatus 206 may update the cluster list by updating the read level voltage of the existing read level cluster to the recalibrated read level voltage. Subsequently, the apparatus 206 may perform the read operation on the current memory block based on the recalibrated read level voltage in response to a future read operation request received for the current memory block.

In an embodiment, the optimal read level voltage determined for the current memory block may be determined to be not similar to the existing read level voltages of the corresponding one or more existing read level clusters, based on the predefined similarity threshold. When the optimal read level voltage is determined to be not similar, the apparatus 206 may create a new read level cluster with a new read level voltage equivalent to the optimal read level voltage (determined by triggering recovery algorithm) for the current memory block. In an embodiment, the apparatus 206 may thereafter store the new read level cluster and representative new read level voltage, in the cluster list. Subsequently, the apparatus 206 may perform the read operation on the current memory block based on the new read level voltage in response to a future read operation request received for the current memory block.

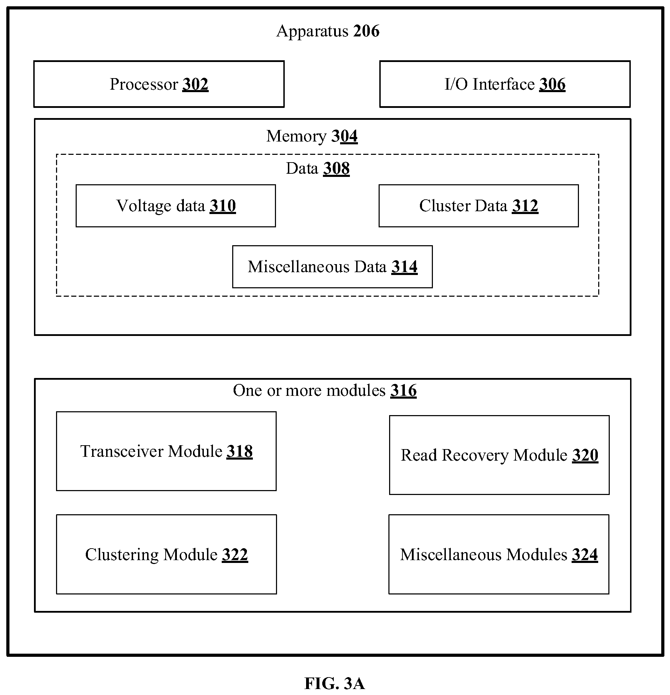

FIG. 3A shows a detailed block diagram of the apparatus 206, in accordance with one or more embodiments of the present disclosure.

In some implementations, the apparatus 206 for performing a read operation on a memory block of a storage device, may include, one or more processors (hereinafter "processor") 302, a memory 304, and an input/output (I/O) interface 306. In an embodiment, the memory 304 may be communicatively coupled to the processor 302. The processor 302 may be configured to perform one or more functions of the apparatus 206, using data 308 and one or more modules 316 of the apparatus 206. In an embodiment, the memory 304 may store data 308.

In some embodiments, the data 308 stored in the memory 304 may include, without limitation, voltage data 310, cluster data 312, and miscellaneous data 314. In some implementations, the data 308 may be stored within the memory 304 in the form of various data structures. Additionally, the data 308 may be organized using data models, such as relational or hierarchical data models. The miscellaneous data 314 may include various temporary data and files generated by the one or more modules 316.

In some embodiments, the voltage data 310 may store default read level voltages of one or more memory blocks, which may be standard read level voltages at which the memory blocks are expected to be read under normal conditions.

In an embodiment, the cluster data 312 may include the existing read level cluster created previously for one or more memory blocks of the storage device. The cluster data 312 may also include the new read level cluster(s) created by the apparatus 206. In an embodiment, the cluster data 312 may include the cluster list comprising one or more read level clusters and one or more representative read level voltages corresponding thereto.

Table 1 provides an exemplary cluster list. As shown in Table 1, the cluster list may include, without limitation, a unique cluster Identifier (ID) for each cluster, the representative read level voltage of each cluster, and a count of memory blocks associated with each cluster. For instance, cluster ID 0 has a representative read level voltage A and is associated with X number of memory blocks, and cluster ID 1 has a representative read level voltage B with Y memory blocks.

**Table 1:**

| Cluster ID | Representative read level | Block count |
|---|---|---|
| 0 | Representative read level A | X |
| 1 | Representative read level B | Y |
| 2 | Representative read level C | Z |
| ... | -- | ... |
| N | Representative read level N | .. |

In an embodiment, the data 308 may be processed by the one or more modules 316 of the apparatus 206 for performing a read operation on a memory block of a storage device. In some implementations, the one or more modules 316 may be communicatively coupled to the processor 302 for performing one or more functions of the apparatus 206. In an implementation, the one or more modules 316 may include, without limiting to, a transceiver module 318, a read recovery module 320, a clustering module 322, and miscellaneous modules 324.

As used herein, the term "module" may refer to an application specific integrated circuit (ASIC), a field-programmable gate array (FPGA), an electronic circuit, a hardware processor (shared, dedicated, or group) and a memory that executes one or more software or firmware programs, a combinational logic circuit, and/or other suitable components that provide the described functionality. In an implementation, each of the one or more modules 316 may be configured as stand-alone hardware computing units. In an embodiment, the miscellaneous modules 324 may be used to perform various miscellaneous functionalities of the apparatus 206. It would be appreciated that such one or more modules 316 may be represented as a single module or a combination of different modules.

In an embodiment, the transceiver module 318 may manage communication between the host 204 and the storage device 202. The transceiver module 318 may be configured to receive a read operation request or write operation request from the host 204. The read operation request or the write operation request from the host 204 may include an address of a memory block to be accessed.

In an embodiment, upon performing a read operation, based on the request received form the host 204, the transceiver module 318 may transmit the data to the host 204. In some embodiments, the host 204 may verify integrity of the received data and may send an acknowledgment to the storage device 202, through the transceiver module 318.

In an embodiment, the read recovery module 320, upon receiving the read operation request from the host 204, may be configured to perform a read operation on the current memory block of the storage device 202 using the default read level voltage. Further, when the read operation fails (e.g., due to any one of scenarios explained below), the read recovery module 320 may be configured to determine the optimal read level voltage for the current memory block.

In an embodiment, in one scenario, upon receiving the read operation request, the read recovery module 320 may perform a read operation to read data from the current memory block using the default read level voltage. If the default read level voltage of the current memory block is an incompatible read level voltage for performing the read operation of the current memory block, the read operation performed on the current memory block fails. In some embodiments, when the read operation on the current memory block fails due to an incompatible read level voltage applied for the read operation, the data retrieved from the memory block may be incorrect. This means the voltage used for performing the read operation does not match a required read level voltage for accurately accessing the stored data, resulting in erroneous data retrieval.

In an embodiment, when the read operation performed on the current memory block fails due to an incompatible read level voltage applied for the read operation, the read recovery module 320 may be configured to perform error check on the data retrieved from the memory block using error-correcting code (ECC). In some embodiments, the memory controller 208 may perform the error check. If the data retrieved from the memory block is error-free or within a correctable range, the processor may transmit the retrieved data to the host 204. In an embodiment, if an error rate exceeds ECC's correction capability, the read recovery module 320 may check a cluster list to determine presence of one or more existing read level clusters. If the one or more existing read level clusters are determined to be present, the read recovery module 320 may attempt to perform the read operation through existing one or more read level voltages corresponding to one or more existing read level clusters (one or more read level clusters already established in the cluster list) and determine if the existing one or more read level voltages are compatible for performing the read operation. Upon determining that at least one existing read level voltage of the one or more existing read level voltages corresponding to the one or more existing read level clusters (one or more read level clusters already established in the cluster list) is compatible for performing the read operation, the read recovery module 320 may perform the read operation on the current memory block based on the at least one existing read level voltage, thereby preventing triggering of the read recovery technique.

In some embodiments, upon determining that any the existing read level voltages corresponding to the one or more existing read level clusters (read level clusters already established in the cluster list) is compatible for performing the read operation, the read recovery module 320 may trigger a read recovery algorithm, and determining the optimal read voltage for the current memory block.

In an embodiment, the clustering module 322 may be configured to characterize groups of memory blocks that undergo similar conditioning processes. The clustering module 322 may be configured to store a single representative read level voltage for each cluster in the cluster list.

In an embodiment, the clustering module 322, based on the optimal read level voltage determined for the current memory block, may determine a recalibrated read level voltage for an existing read level cluster among one or more existing read level clusters created previously for one or more memory blocks of the storage device. In an embodiment, the recalibrated read level voltage may be determined when the optimal read level voltage determined for the current memory block is determined to be similar to the existing read level voltage of the existing read level cluster among the one or more existing read level clusters, based on a predefined similarity threshold. In an embodiment, if the clustering module 322 determines that the optimal read level voltage for the current memory block is not similar to the existing read level voltages of the corresponding one or more existing read level clusters, based on the predefined similarity threshold, the clustering module 322 may create a new read level cluster with a new read level voltage equivalent to the optimal read level voltage (determined by triggering recovery algorithm) for the current memory block. In an embodiment, the clustering module 322 may thereafter store the new read level cluster and representative new read level voltage, in the cluster list. Subsequently, the clustering module 322 may perform the read operation on the current memory block based on the new read level voltage in response to a future read operation request received for the current memory block.

In an embodiment, when the optimal read level voltage determined for the current memory block is determined to be similar to the existing read level voltage of the existing read level cluster among the one or more existing read level clusters, prior to determining the recalibrated read level voltage, the clustering module 322 may select the existing read level cluster among the one or more existing read level clusters for recalibration based on the similarity of the optimal read level voltage to the existing read level voltage(s) of each of the corresponding one or more existing read level clusters.

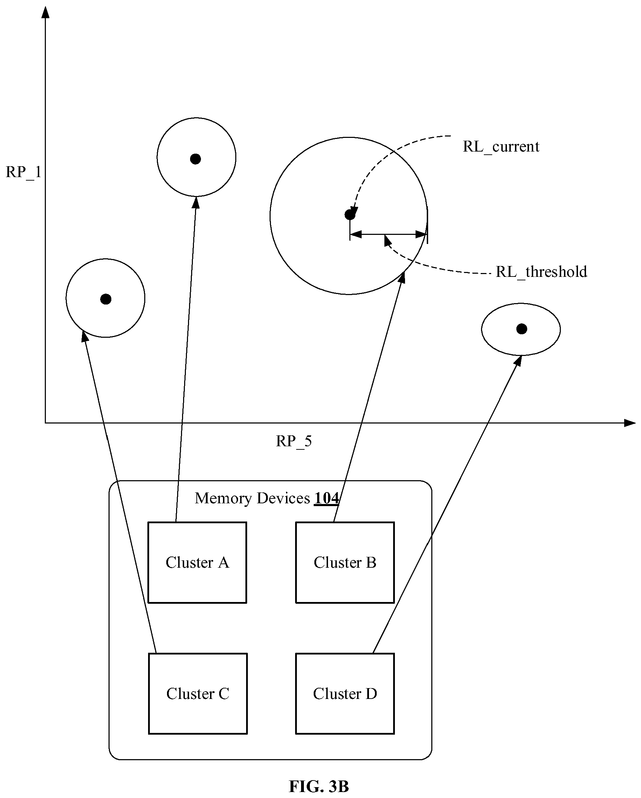

FIG. 3B shows an exemplary illustration of one or more clusters, in accordance with one or more embodiments of the present disclosure. As shown in FIG. 3B, one or more existing read level clusters may include Group A, Group B, Group C, and Group D, each comprising one or more memory blocks previously mapped to one or more existing read level clusters. The existing read level voltage (or representative read level voltage or cluster center voltage) of the existing read level cluster is denoted as *RL_current.* The predefined similarity threshold is denoted as *RL_threshold.*

In an embodiment, when the current memory block with optimal read level voltage (*RL*_*optimal,* not explicitly shown in FIG. 3B but implied) is determined, the *RL*_*optimal* is compared to the *RL*_*current* of each of existing clusters. If a difference between the *RL*_*optimal* and the *RL*_*current* of one existing read level cluster is within the *RL*_*threshold,* the one existing read level cluster among the one or more existing read level clusters is selected, i.e., if $Mod \left|{RL}_{current}-{RL}_{optimal}\right| < {RL}_{threshold}$

the one existing read level cluster among the one or more existing read level clusters is selected. Upon selecting the existing read level cluster, the current block with optimal read level voltage *RL*_*optimal* may be mapped to the selected existing read level cluster. Further, the *RL*_*current* of the selected existing read level cluster may be recalibrated *to RL new.*

In an embodiment, without limitation, the recalibrated read level voltage for the existing read level cluster may be determined by the clustering module 322 based on the existing read level voltage of the existing read level cluster, a total number of memory blocks previously mapped to the existing read level cluster (*CLR_count*), and the optimal read level voltage determined for the current memory block.

In some embodiments, the recalibrated read level voltage for the existing read level cluster may be, without limitation, a weighted running average voltage. The weighted running average voltage may be computed using the equation below: ${RL}_{new} = \frac{{CLR}_{count} ∗ {RL}_{current} + {RL}_{optimal}}{1 + {CLR}_{count}}$

In an embodiment, the clustering module 322 may create a new read level cluster with respect to a new read level voltage equivalent to the optimal read level voltage for the current memory block, when the optimal read level voltage determined for the current memory block is determined to be not similar to the one or more existing read level voltages of the corresponding one or more existing read level clusters, based on a predefined similarity threshold. As an example, when the *RL*_*optimal* is compared to the *RL*_*current* of existing clusters and if the difference between the *RL*_*optimal* and *RL*_*current* is not within the *RL*_*threshold,* i.e., if $Mod \left|{RL}_{current}-{RL}_{optimal}\right| > {RL}_{threshold}$

the clustering module 322 may create the new read level cluster with respect to the new read level voltage equivalent to the optimal read level voltage for the current memory block.

As an example, consider four existing clusters (A, B, C, and D) in the storage device 202 defined as follows: Cluster A *(RL*_*current =* 1.0V, *CLR count =* 10), Cluster B (*RL*_*current =* 2.5V, *CLR count =* 15), Cluster C (*RL*_*current =* 4.0V, *CLR count =* 20), and Cluster D (*RL*_*current =* 5.5V, *CLR count =* 5). The similarity threshold (*RL*_*threshold*) may be set to 0.5V. When the optimal read level voltage for a current memory block is determined, *RL*_*optimal* may be determined to be 2.3V. This *RL*_*optimal* may be compared to the *RL*_*current* of each existing cluster. The differences are: $\left|2.3V-1.0V\right| = 1.3 V$ $\left|2.3V-2.5V\right| = 0.2 V$ $\left|2.3V-4.0V\right| = 1.7 V$ and $\left|2.3V-5.5V\right| = 3.2 V$

Since the difference between the *RL*_*optimal* (2.3V) and Cluster B's *RL*_*current* (2.5V) is 0.2V, which is within the *RL*_*threshold* of 0.5V, Cluster B may be selected for recalibration. The new *RL*_*new* for Cluster B may be calculated using a weighted average: *RL_new* = 2.48V (approximately). The current memory block may then be mapped to Cluster B, and Cluster B's *RL*_*current* may be updated to 2.48V. The processor 302 may perform the read operation on the current memory block based on the recalibrated read level voltage, i.e., *RL*_*current* =2.48V, in response to a future read operation request received for the current memory block.

In an alternate scenario, if the *RL*_*optimal* is say, 6.0V, which is outside a similarity of *RL*_*threshold* for all existing clusters, the clustering module 322 may create a new read level cluster with a new read level voltage, i.e. with *RL*_*current =* 6.0V. The processor 302 may perform the read operation on the current memory block based on the new read level voltage *RL*_*current =* 6.0V, in response to a future read operation request received for the current memory block.

In an embodiment, the clustering module 322 may store a cluster list comprising one or more read level clusters and one or more representative read level voltages thereof. In an embodiment, the one or more read level clusters may include at least one of the one or more existing read level clusters and one or more newly created read level clusters. In an embodiment, the cluster list may be dynamically updated based on a number of memory blocks in the one or more existing read level clusters. In some embodiments, without limitation, the cluster list may be dynamically organized based on a number of memory blocks in each cluster, the *CLR count.* For example, Cluster A has a *CLR count* =10 memory blocks, Cluster B has *CLR count* =15 memory blocks, Cluster C has a *CLR_count*= 20 memory blocks, and Cluster D has *CLR count* =5 memory blocks. In some embodiments, the cluster list may be arranged in an ascending order of the *CLR count.* In some other embodiments, the cluster list may be arranged in an order of formation of clusters.

In an embodiment, the clustering module 322 may be configured to perform cluster destruction of the one or more existing clusters. In an embodiment, cluster destruction may be performed based on one or more factors, including a garbage collection operation and a period of inactivity. When garbage collection is performed on memory blocks mapped to a read level cluster, data within that the read level cluster becomes invalid, triggering the clustering module 322 to initiate cluster destruction. In some embodiments, the clustering module 322 may monitor a read level cluster usage. If the one or more memory blocks mapped to the read level cluster are no longer in use and/or if the one or more memory blocks mapped to the read level cluster remained inactive for an extended period, the clustering module 322 may remove the corresponding read level cluster from the cluster list, effectively destroying the read level cluster.

In some embodiments, the clustering module 322 may be configured to perform the destruction of one or more existing clusters when a new read level cluster is created. In such scenarios, if one or more memory blocks mapped to the read level cluster are no longer in use and/or have remained inactive for an extended period, the clustering module 322 may remove the corresponding read level cluster from the cluster list to add the new read level cluster.

In an embodiment, the clustering module 322 may be configured to perform cluster destruction of the one or more existing clusters, upon power off the storage device 202.

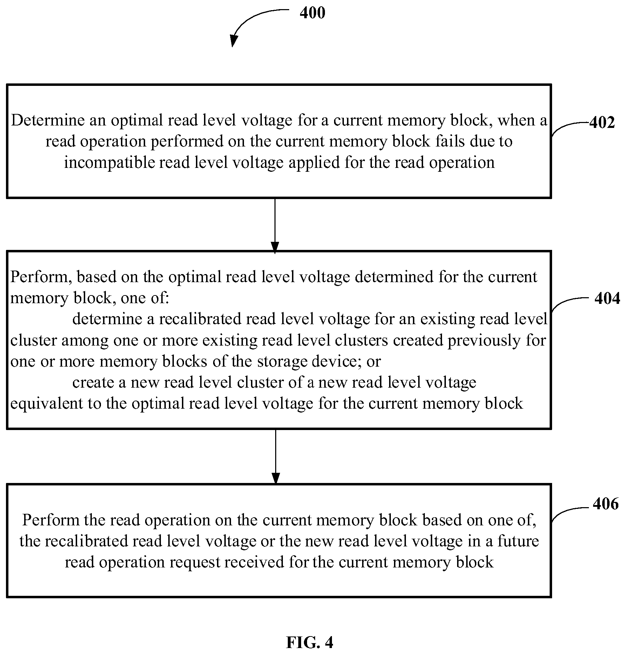

FIG. 4 shows a flowchart illustrating a method 400 of performing read operation on a memory block of a storage device, in accordance with one or more embodiments of the present disclosure.

As illustrated in FIG. 4, the method 400 may include one or more blocks illustrating a method of performing a read operation on a memory block of a storage device 202 using the processor 302 configured in the apparatus 206 illustrated in FIG. 4. The method 400 may be described in a general context of computer executable instructions. Generally, computer executable instructions may include routines, programs, objects, components, data structures, procedures, modules, and functions, which perform specific functions or implement specific abstract data types.

The order in which the method 400 is described is not intended to be construed as a limitation, and any number of the described method blocks may be combined in any order to implement the method. Additionally, individual blocks may be deleted from the methods without departing from the scope of the subject matter described herein. Furthermore, the method may be implemented in any suitable hardware, software, firmware, or combination thereof.

At block 402, the method 400 may include determining, by a processor 302, an optimal read level voltage for a current memory block, when a read operation performed on the current memory block fails due to an incompatible read level voltage applied for the read operation. In an embodiment, the read operation performed on the current memory block fails when a default read level voltage of the current memory block is incompatible read level voltage for performing the read operation of the current memory block. In some embodiments, the read operation performed on the current memory block fails when a default read level voltage of the current memory block and one or more existing read level voltages corresponding to the one or more existing read level clusters are determined to be incompatible read level voltages for performing the read operation of the current memory block.

At block 404, the method 400 may include, performing, by the processor 302, based on the optimal read level voltage determined for the current memory block, one of: determining a recalibrated read level voltage for an existing read level cluster among one or more existing read level clusters created previously for one or more memory blocks of the storage device; or creating a new read level cluster with a new read level voltage equivalent to the optimal read level voltage for the current memory block. In an embodiment, the recalibrated read level voltage may be determined when the optimal read level voltage determined for the current memory block is determined to be similar to the existing read level voltage of the existing read level cluster among the one or more existing read level clusters, based on a predefined similarity threshold. In an embodiment, prior to determining the recalibrated read level voltage, the processor 302 may select the existing read level cluster among the one or more existing read level clusters for recalibration based on a similarity of existing read level voltages of each of the corresponding one or more existing read level clusters to the optimal read level voltage. In an embodiment, the recalibrated read level voltage for the existing read level cluster may be determined based on the existing read level voltage of the existing read level cluster, the total number of memory blocks previously mapped to the existing read level cluster, and the optimal read level voltage determined for the current memory block. In an embodiment, the new read level cluster with the new read level voltage may be created when the optimal read level voltage determined for the current memory block is determined to be not similar to the existing read level voltages of the corresponding one or more existing read level clusters, based on a predefined similarity threshold.

At block 406, the method 400 may include, performing, by the processor 302, the read operation on the current memory block based on one of the recalibrated read level voltage or the new read level voltage in response to a future read operation request received for the current memory block.

### Computer System

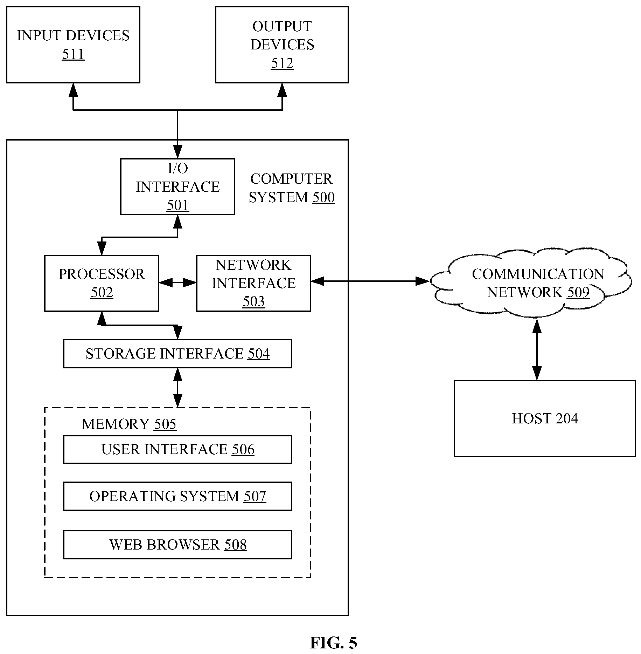

FIG. 5 illustrates a block diagram of an exemplary computer system 500 for implementing embodiments consistent with the present disclosure. In an embodiment, the computer system 500 may correspond to the apparatus 206 described above. The computer system 500 may be communicatively connected to a host 204 associated with a storage server. In some embodiments, the apparatus 206 may be configured within the storage device 202. The computer system 500 may include a central processing unit ("CPU" or "processor" or "memory controller") 502.

The processor 502 may comprise at least one data processor for executing program components for executing user- or system-generated host application execution processes. A user may include, for example but not limited to, an administrator, a network manager, an application developer, a programmer, an organization, or any system/sub-system being operated parallelly to the computer system 500. The processor 502 may include specialized processing units such as integrated system (bus) controllers, memory controllers/memory management control units, floating point units, graphics processing units, digital signal processing units, etc.

The processor 502 may be disposed in communication with one or more Input/Output (I/O) devices 511 and 512 via an I/O interface 501. The I/O interface 501 may employ communication protocols/methods such as, without limitation, audio, analog, digital, stereo, IEEE^{®}-1395, serial bus, Universal Serial Bus (USB), infrared, PS/2, BNC, coaxial, component, composite, Digital Visual Interface (DVI), high-definition multimedia interface (HDMI), Radio Frequency (RF) antennas, S-Video, Video Graphics Array (VGA), IEEE^{®} 802.n /b/g/n/x, Bluetooth, cellular (e.g., Code-Division Multiple Access (CDMA), HighSpeed Packet Access (HSPA+), Global System For Mobile Communications (GSM), Long-Term Evolution (LTE) or the like), etc. Using the I/O interface 501, the computer system 500 may communicate with one or more I/O devices 511 and 512.

In some embodiments, the processor 502 may be disposed in communication with a network 509 via a network interface 503. The network interface 503 may communicate with the network 509. The network interface 503 may employ connection protocols including, without limitation, direct connect, Ethernet (e.g., twisted pair 10/100/1000 Base T), Transmission Control Protocol/Internet Protocol (TCP/IP), token ring, IEEE^{®} 802.11a/b/g/n/x, etc.

In an implementation, the network 509 may be implemented as one of the several types of networks, such as intranet or Local Area Network (LAN) and such within the organization. The network 509 may either be a dedicated network or a shared network, which represents an association of several types of networks that use a variety of protocols, for example, Hypertext Transfer Protocol (HTTP), Transmission Control Protocol/Internet Protocol (TCP/IP), Wireless Application Protocol (WAP) etc., to communicate with each other. Further, the network 509 may include a variety of network devices, including routers, bridges, servers, computing devices, storage devices, etc.

In some embodiments, the processor 502 may be disposed in communication with a memory 505 via a storage interface 504. The storage interface 504 may connect to the memory 505 including, without limitation, memory drives, removable disc drives, etc., employing connection protocols such as Serial Advanced Technology Attachment (SATA), Integrated Drive Electronics (IDE), IEEE-1395, Universal Serial Bus (USB), fiber channel, Small Computer Systems Interface (SCSI), etc. The memory drives may further include a drum, magnetic disc drive, magneto-optical drive, optical drive, Redundant Array of Independent Discs (RAID), a solid-state memory device, a solid-state drive, etc.

The memory 505 may store a collection of program or database components, including, without limitation, a user interface (or application interface) 506, an operating system 507, a web browser 508, and the like. In some embodiments, the computer system 500 may store user/application data, such as the data, variables, records, etc. as described in the disclosure. Such databases may be implemented as fault-tolerant, relational, scalable, secure databases such as Oracle^{®} or Sybase^{®}.

The operating system 507 may facilitate resource management and operation of the computer system 500. Examples of operating systems include, without limitation, APPLE^{®} MACINTOSH^{®} OS X^{®}, UNIX^{®}, UNIX-like system distributions (E.G., BERKELEY SOFTWARE DISTRIBUTION^{®} (BSD), FREEBSD^{®}, NETBSD^{®}, OPENBSD, etc.), LINUX^{®} DISTRIBUTIONS (E.G., RED HAT^{®}, UBUNTU^{®}, KUBUNTU^{®}, etc.), IBM^{®} OS/2^{®}, MICROSOFT^{®} WINDOWS^{®} (XP^{®}, VISTA^{®}/7/8, 10 etc.), APPLE^{®} IOS^{®}, GOOGLE TM ANDROID TM, BLACKBERRY^{®} OS, or the like.

The user interface 506 may facilitate display, execution, interaction, manipulation, or operation of program components through textual or graphical facilities. For example, the user interface 506 may provide computer interaction interface elements on a display system operatively connected to the computer system 500, such as cursors, icons, check boxes, menus, scrollers, windows, widgets, and the like. Further, Graphical User Interfaces (GUIs) may be employed, including, without limitation, APPLE^{®} MACINTOSH^{®} operating systems' Aqua^{®}, IBM^{®} OS/2^{®}, MICROSOFT^{®} WINDOWS^{®} (e.g., Aero, Metro, etc.), web interface libraries (e.g., ActiveX^{®}, JAVA^{®}, JAVASCRIPT^{®}, AJAX, HTML, ADOBE^{®} FLASH^{®}, etc.), or the like.

The web browser 508 may be a hypertext viewing application. Secure web browsing may be provided using Secure Hypertext Transport Protocol (HTTPS), Secure Sockets Layer (SSL), Transport Layer Security (TLS), and the like. The web browsers 508 may utilize facilities such as AJAX, DHTML, ADOBE^{®} FLASH^{®}, JAVASCRIPT^{®}, JAVA^{®}, Application Programming Interfaces (APIs), and the like. Further, the computer system 500 may implement a mail server stored program component. The mail server may utilize facilities such as ASP, ACTIVEX^{®}, ANSI^{®} C++/C#, MICROSOFT^{®}, .NET, CGI SCRIPTS, JAVA^{®}, JAVASCRIPT^{®}, PERL^{®}, PHP, PYTHON^{®}, WEBOBJECTS^{®}, etc. The mail server may utilize communication protocols such as Internet Message Access Protocol (IMAP), Messaging Application Programming Interface (MAPI), MICROSOFT^{®} exchange, Post Office Protocol (POP), Simple Mail Transfer Protocol (SMTP), or the like. In some embodiments, the computer system 500 may implement a mail client stored program component. The mail client may be a mail viewing application, such as APPLE^{®} MAIL, MICROSOFT^{®} ENTOURAGE^{®}, MICROSOFT^{®} OUTLOOK^{®}, MOZILLA^{®} THUNDERBIRD^{®}, and the like.

Furthermore, one or more computer-readable storage media may be utilized in implementing embodiments consistent with the present disclosure. A computer-readable storage medium may refer to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., non-transitory. Examples include Random Access Memory (RAM), Read-Only Memory (ROM), volatile memory, nonvolatile memory, hard drives, Compact Disc (CD) ROMs, Digital Video Disc (DVDs), flash drives, disks, and any other known physical storage media.

The present disclosure provides a method and an apparatus for performing read operations on a memory block of a storage device.

The present disclosure proposes clustering blocks with similar reliability conditions and maintains a cluster list comprising one or more read level clusters and representative read level voltages, thereby minimizing the need for repeated recovery scheme triggers, while performing a read operation on the memory block.

The present disclosure provides a more efficient way to store the read level voltages. Instead of maintaining a complete and large list of read level voltages for each memory block, the present disclosure may maintain the list of one or more read level clusters and representative read level voltages, resulting in a significantly lower memory footprint. This reduction in memory overhead translates to lower storage costs and improved energy efficiency, which are critical considerations in memory device design.

As stated above, it should be noted that the method of the present disclosure may be used to overcome various technical problems related to non-volatile memory management. In other words, the disclosed method has a practical application and provides a technically advanced solution to the technical problems associated with the existing approach into non-volatile memory management.

The terms "an embodiment", "embodiment", "embodiments", "the embodiment", "the embodiments", "one or more embodiments", "some embodiments", and "one embodiment" mean "one or more (but not all) embodiments of the invention(s)" unless expressly specified otherwise.

The terms "including", "comprising", "having" and variations thereof mean "including but not limited to", unless expressly specified otherwise.

The enumerated listing of items does not imply that any or all the items are mutually exclusive, unless expressly specified otherwise. The terms "a", "an" and "the" mean "one or more", unless expressly specified otherwise.

A description of an embodiment with several components in communication with each other does not imply that all such components are required. On the contrary, a variety of optional components are described to illustrate the wide variety of possible embodiments of the disclosure.

When a single device or article is described herein, it will be clear that more than one device/article (whether they cooperate) may be used in place of a single device/article. Similarly, where more than one device/article is described herein (whether they cooperate), it will be clear that a single device/article may be used in place of the more than one device/article or a different number of devices/articles may be used instead of the shown number of devices or programs. The functionality and/or features of a device may be alternatively embodied by one or more other devices which are not explicitly described as having such functionality/features. Thus, other embodiments of the disclosure need not include the device itself.

Finally, the language used in the specification has been principally selected for readability and instructional purposes, and it may not have been selected to delineate or circumscribe the inventive subject matter. While various aspects and embodiments have been disclosed herein, other aspects and embodiments will be apparent to those skilled in the art.

At least one of the components, elements, modules or units (collectively "components" in this paragraph) represented by a block in the drawings, may be embodied as various numbers of hardware, software and/or firmware structures that execute respective functions described above, according to one or more example embodiments. For example, at least one of these components may use a direct circuit structure, such as a memory, a processor, a logic circuit, a look-up table, etc. that may execute the respective functions through controls of one or more microprocessors or other control apparatuses. Also, at least one of these components may be specifically embodied by a module, a program, or a part of code, which contains one or more executable instructions for performing specified logic functions, and executed by one or more microprocessors or other control apparatuses. Further, at least one of these components may include or may be implemented by a processor such as a central processing unit (CPU) that performs the respective functions, a microprocessor, or the like. Two or more of these components may be combined into one single component which performs all operations or functions of the combined two or more components. Also, at least part of functions of at least one of these components may be performed by another of these components. Further, although a bus is not illustrated in the above block diagrams, communication between the components may be performed through the bus. Functional aspects of the above example embodiments may be implemented in algorithms that execute on one or more processors. Furthermore, the components represented by a block or processing steps may employ any number of related art techniques for electronics configuration, signal processing and/or control, data processing and the like.

While the disclosure has been particularly illustrated and described with reference to example embodiments thereof, it will be understood that various changes in form and details may be made therein without departing from the spirit and scope of the following claims.

## Claims

1. A method of performing a read operation on a memory block of a storage device, by at least one processor, the method comprising:
determining an optimal read level voltage for a current memory block, based on a failure of a read operation performed on the current memory block due to an incompatible read level voltage applied for the read operation;
performing, based on the optimal read level voltage determined for the current memory block, one of:
determining a recalibrated read level voltage for an existing read level cluster among one or more existing read level clusters created previously for one or more memory blocks of the storage device; and
creating a new read level cluster with respect to a new read level voltage equivalent to the optimal read level voltage for the current memory block; and
performing, based on a subsequent read operation request for the current memory block, the read operation on the current memory block based on the recalibrated read level voltage or the new read level voltage.

2. The method as claimed in claim 1, wherein the determining the optimal read level voltage comprises determining the optimal read level voltage for the current memory block, based on the failure of the read operation performed on the current memory block due to a default read level voltage of the current memory block, which is the incompatible read level voltage, applied for the read operation of the current memory block.

3. The method as claimed in claim 1, wherein the determining the optimal read level voltage comprises determining the optimal read level voltage for the current memory block, based on the read operation performed on the current memory block failing due to a default read level voltage of the current memory block, which is the incompatible read level voltage, applied for the read operation of the current memory block, and further based on the one or more existing read level clusters not including at least one existing read level voltage that is a compatible read level voltage for performing the read operation of the current memory block.

4. The method as claimed in claim 1, wherein the determining the recalibrated read level voltage comprises determining the recalibrated read level voltage for the existing read level cluster based on a similarity of the optimal read level voltage determined for the current memory block to an existing read level voltage of the existing read level cluster, among the one or more existing read level clusters, satisfying a predefined similarity threshold.

5. The method as claimed in claim 1, further comprising, prior to determining the recalibrated read level voltage:
selecting the existing read level cluster for recalibration, among the one or more existing read level clusters, based on a similarity of each of one or more existing read level voltages of the one or more existing read level clusters to the optimal read level voltage.

6. The method as claimed in claim 1, wherein the determining the recalibrated read level voltage comprises determining the recalibrated read level voltage for the existing read level cluster based on an existing read level voltage of the existing read level cluster, a total number of memory blocks previously mapped to the existing read level cluster, and the optimal read level voltage determined for the current memory block.

7. The method as claimed in claim 1, wherein the creating the new read level cluster comprises creating the new read level cluster with respect to the new read level voltage based on a similarity of the optimal read level voltage determined for the current memory block to one or more existing read level voltages of the one or more existing read level clusters not satisfying a predefined similarity threshold.

8. The method as claimed in claim 1, further comprises:
storing a cluster list comprising one or more read level clusters and one or more representative read level voltages of the one or more read level clusters, wherein the one or more read level clusters comprises at least one of the one or more existing read level clusters and one or more newly created read level clusters.

9. The method as claimed in claim 8, further comprises dynamically updating the cluster list based on a number of memory blocks in the one or more existing read level clusters.

10. The method as claimed in claim 1, wherein the determining the optimal read level voltage comprises determining the optimal read level voltage based on a read recovery algorithm that is triggered by the failure of the read operation performed on the current memory block.

11. An apparatus for performing a read operation on a memory block of a storage device, the apparatus comprising:
at least one processor; and
a memory, communicatively coupled to the at least one processor, wherein the memory stores instructions, which, on execution, causes the at least one processor to:
determine an optimal read level voltage for a current memory block, based on a failure of a read operation performed on the current memory block due to incompatible read level voltage applied for the read operation;
perform, based on the optimal read level voltage determined for the current memory block, one of:
determine a recalibrated read level voltage for an existing read level cluster among one or more existing read level clusters created previously for one or more memory blocks of the storage device; and
create a new read level cluster with respect to a new read level voltage equivalent to the optimal read level voltage for the current memory block; and
perform, based on a subsequent read operation request for the current memory block, the read operation on the current memory block based on the recalibrated read level voltage or the new read level voltage.

12. The apparatus as claimed in claim 11, wherein the at least one processor is configured to determine the optimal read level voltage based on the failure of the read operation performed on the current memory block due to a default read level voltage of the current memory block, which is the incompatible read level voltage, applied for the read operation of the current memory block.

13. The apparatus as claimed in claim 11, wherein the at least one processor is configured to determine the optimal read level voltage based on the failure of the read operation performed on the current memory block due to a default read level voltage of the current memory block, which is the incompatible read level voltage, applied for the read operation of the current memory block, and further based on the one or more existing read level clusters not including at least one existing read level voltage that is a compatible read level voltage for performing the read operation of the current memory block.

14. The apparatus as claimed in claim 11, wherein the at least one processor is configured to determine the recalibrated read level voltage for the existing read level cluster based on a similarity of the optimal read level voltage determined for the current memory block to an existing read level voltage of the existing read level cluster, among the one or more existing read level clusters, satisfying a predefined similarity threshold.

15. The apparatus as claimed in claim 11, wherein the at least one processor is configured to, prior to determining the recalibrated read level voltage:
select the existing read level cluster for recalibration, among the one or more existing read level clusters, based on a similarity of each of one or more existing read level voltages of the one or more existing read level clusters to the optimal read level voltage.
